# EUROPÄISCHE PATENTANMELDUNG

(11) **EP 1 684 304 A2**
(43) Veröffentlichungstag der Anmeldung: **26.07.2006**
(21) Anmeldenummer: 05028556.8
(22) Anmeldetag: 28.12.2005
(51) Int. Cl.: G11C 11/02, B05D 1/18

(54) **Neuartige Anbindung organischer Moleküle an eine Siliziumoberfläche zur Herstellung von Speicherelementen mit organischen Bestandteilen**

(30) Priorität: 25.01.2005 DE 102005003475
(71) Anmelder: Infineon Technologies AG, 81669 München (DE)
(72) Erfinder: Ufert, Klaus, 85716 Unterschleissheim (DE)
(74) Vertreter: Behnisch, Werner

(57) **Zusammenfassung**

Die vorliegende Erfindung betrifft ein nichtflüchtiges Speicherelement, in dem organische Moleküle über eine neuartige Endgruppe an Siliziumoberflächen, insbesondere über den Stickstoff einer Nitrilgruppe an eine Siliziumoberfläche oder an eine nitridierte Siliziumoberfläche, gebunden werden. Das organische Molekül stellt eine leitende Verbindung zwischen zwei Kontakten her. Erfindungsgemäß ist dabei einer der beiden Kontakte ein Siliziumsubstrat. Das organische Molekül ist abwechselnd aus Ethinyl- und Arylgruppierungen aufgebaut. An einem Ende dieser Kette befindet sich eine Cyangruppe zur Anbindung des organischen Moleküls an das Substrat. Diese Cyangruppe ist Teil einer Gruppe, ausgewählt aus Benzonitril, Phenylacetonitril, Benzoylacetonitril und Benzoylcyanid.

## Beschreibung

Die vorliegende Erfindung betrifft ein nichtflüchtiges Speicherelement, in dem organische Moleküle über eine neuartige Endgruppe an Siliziumoberflächen, insbesondere über den Stickstoff einer Nitrilgruppe an eine Siliziumoberfläche oder an eine nitridierte Siliziumoberfläche, gebunden werden.

Da die Miniaturisierung von Halbleiterelementen stetig voranschreitet und die klassischen Verfahren des Ätzens von Strukturen an absehbare Grenzen stoßen werden, müssen neuartige Strukturen entwickelt werden. Ein verheißungsvoller Ansatz ist der Einsatz von organischen Molekülen in Halbleiterelementen. Beispielsweise können konjugierte Oligophenylenethinylene als molekulare Drähte in Bauteilen (mit nichtlinearen I(V) Kurven oder für dynamische Schreib-/Lesezugriffspeicher (DRAM)) eingesetzt werden.

Die bisher eingesetzten Speicherkonzepte (floating gate memories wie Flash und DRAM) beruhen auf der Speicherung von Ladungen in anorganischen, siliziumbasierenden Materialen. Im Gegensatz dazu können organische Moleküle, wie z.B. Amino-4-ethinylphenylbenzenthiol, die in einer selbstorganisierten molekularen Monolage auf einer Goldschicht aufwachsen, die Speicherung von Information nach dem Prinzip des resistiven Schaltens zwischen zwei stabilen Widerstandszuständen in den organischen Molekülen realisieren.

Die Herstellung von Oligophenylenethinylenen mit Hilfe bekannter organischer Synthesemethoden ist in der Literatur beschrieben. So beschreiben zum Beispiel Moroni et al. (Macromolecules 1997, 30, 1964-1972) die Kopplung von Acetylenderivaten mit Phenylderivaten durch Katalyse an Platin oder Palladium. Die Herstellung der organischen Moleküle zum Einsatz in den Halbleiterelementen wird auch von Tour et al. beschrieben (Chem. Eur. J. 2001, 7, Nr. 23, 5118-5134).

Den Aufbau einer Testumgebung beschreiben Chen et al. in Science, Vol. 286, 1550-1552. In der letztgenannten Veröffentlichung ebenso wie auch in Reed et al. (Applied Physics Letters, Vol. 78, Nr. 23, 3735-3737) und Chao Li et al. (Applied Physics Letters, Vol. 82, Nr. 4, 645-647) werden Metallkontakte, bevorzugt Gold, als Oberfläche verwendet, auf die organische Moleküle aufgetragen werden. Die Auftragung erfolgt über den Mechanismus der selbstorganisierten Monolagen (self-assembled monolayers, SAM). Dabei binden die Moleküle mit Hilfe des Schwefels über eine Thiol-Einheit an die Goldoberfläche. Anschließend wird auf die Schicht aus organischen Molekülen ein sogenannter Top-Kontakt aufgebracht. Dieser stellt den zweiten Kontakt für die Moleküle dar. Die organischen Moleküle bilden damit eine Verbindung, einen molekularen Draht, zwischen den beiden Metallkontakten.

Ein wesentliches Problem stellt die Bindung eines organischen Moleküls an ein Substrat dar. Bisher erfolgt die Anbindung der organischen Moleküle nur mittels Thiol (SH) Gruppen an eine Substratschicht aus Gold. Dabei ist besonders die Haftung des Moleküls an dem Metall oftmals schlecht. Die organischen Moleküle werden in Form von selbstorganisierten molekularen Monolagen auf dem Substrat aufgebracht. Die Verankerung erfolgt über die sogenannte End- bzw. Attachment-Molekülgruppe. Die Bindung ist oft niederenergetisch und selten chemisch kovalent. Außerdem ist die Adhäsion stark von der Morphologie des Substrates abhängig. Daher sind das Leitfähigkeitsverhalten und die Strom-Spannungs-Charakteristik solcher organischer Molekular-Halbleiterelemente oft nicht reproduzierbar und variieren stark mit den Eigenschaften des ungenügenden Kontaktes zwischen dem organischen Molekül und dem Substrat.

Die Endgruppe ist für die chemische Verbindung und die mechanische Adhäsion des organischen Moleküls zu dem Substrat verantwortlich. Ist der chemische und mechanische Kontakt nicht optimal, so wird der Elektronentransfer (die elektrische Leitfähigkeit) über diese Molekül-Substrat-Brücke gestört. Ein Maß dafür ist die sogenannte Leitfähigkeitslücke.

Für die Integration in die bestehende CMOS Technologie ist jedoch die gute Kopplung an ein Siliziumsubstrat wichtig. Diese kann mit den derzeit eingesetzten Thiolgruppen chemisch und elektrisch nicht befriedigend hergestellt werden. Daher sind die resistiven Speicherzustände nicht kontrollierbar und können nicht optimal eingestellt werden. Es wäre auch vorteilhaft, wenn der zusätzliche Verfahrensschritt des Aufbringens einer Metallschicht entfallen könnte.

Es ist daher ein Ziel der vorliegenden Erfindung, eine Kopplung der organischen Moleküle direkt an ein Siliziumsubstrat zu ermöglichen.

Erfindungsgemäß wird dieses durch das Verfahren des unabhängigen Anspruchs 12 gelöst. Das Ergebnis ist ein nichtflüchtiges Speicherelement in einer Halbleiterstruktur gemäß Anspruch 1.

Das der vorliegenden Erfindung zugrundeliegende Prinzip ist die Anbindung organischer Moleküle über den Stickstoff einer Nitrilgruppe direkt an ein Substrat aus Silizium. Dadurch wird sowohl die chemische als auch die elektrische Verbindung zwischen Molekül und Substrat verbessert. Die im bisherigen Stand der Technik obligatorische Goldkontaktschicht wird damit überflüssig.

Das organische Molekül stellt eine leitende Verbindung zwischen zwei Kontakten her. Erfindungsgemäß ist dabei einer der beiden Kontakte ein Siliziumsubstrat. Das organische Molekül ist abwechselnd aus Ethinyl- und Arylgruppierungen aufgebaut. An einem Ende dieser Kette befindet sich eine Cyangruppe zur Anbindung des organischen Moleküls an das Substrat. Diese Cyangruppe ist Teil einer Gruppe, ausgewählt aus Benzonitril, Phenylacetonitril, Benzoylacetonitril und Benzoylcyanid.

Vorteilhafte Weiterbildungen und Verbesserungen des jeweiligen Erfindungsgegenstandes finden sich in den Unteransprüchen wieder.

In einer bevorzugten Ausführungsform befindet sich an mindestens einer Arylgruppe mindestens eine elektronenziehende Gruppe. Diese kann zum Beispiel NH₂ oder NO₂ sein. In einer weiteren Ausführungsform können auch eines oder mehrere der Kohlenstoffatome der Arylgruppe substituiert sein, um eine elektronenarme Arylgruppierung zu erzeugen. Eine oder mehrere der Arylgruppen können in einer anderen Ausführungsform durch ein substituiertes oder unsubstituiertes Pyridin ersetzt werden.

Die Gruppe, mit der das organische Molekül an den Siliziumkontakt bindet, ist bevorzugt Benzonitril oder Phenylacetonitril.

Das organische Molekül mit alternierenden Ethinyl- und Arylgruppen kann durch folgende Formel I beschrieben werden: 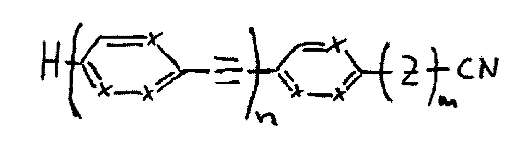 wobei
- n: eine ganze Zahl von 0 bis 10 ist,
- m: 0 oder 1 ist,
- Z: eine Linkergruppe ist, die CH₂, CO oder COCH₂ sein kann, und
- X: unabhängig voneinander in jedem Molekül C-H, N oder C-Y sein kann, wobei Y eine elektronenziehende Gruppe ist.

In obiger Formel I ist Y bevorzugt eine NH₂-Gruppe oder eine NO₂-Gruppe. Z ist bevorzugt eine CH₂-Gruppe oder m ist bevorzugt 0. Die Anzahl der alternierenden Ethinyl- und Arylgruppen wird durch die Zahl n bestimmt. Diese liegt bevorzugt im Bereich von 1 bis 5 und ist noch bevorzugter 2, 3 oder 4.

In einer bevorzugten Ausführungsform ist der Siliziumkontakt eine nitridierte Siliziumoberfläche. Der zweite Kontakt, der sogenannte Topkontakt, kann bevorzugt ein mit Palladium oder Titan beschichtetes Kohlenstoffnanoröhrchen oder ein Goldtopkontakt sein. Letzterer kann z.B. sehr schonend durch Aufdampfen einer Goldschicht im Vakuum bei gekühltem Substrat aufgebacht werden.

Ein weiterer Aspekt der Erfindung betrifft ein Herstellungsverfahren für ein nichtflüchtiges Speicherelement. Hierbei wird in Teilen eine Siliziumoberfläche bereitgestellt, auf der organische Moleküle, die alternierend Ethinyl- und Arylgruppen mit mindestens einer Gruppe, ausgewählt aus Benzonitril, Phenylacetonitril, Benzoylacetonitril und Benzoylcyanid, an dem Ende der organischen Moleküle enthalten, mit dem die Moleküle über die Cyangruppe an die Siliziumoberfläche binden, aufgebracht werden, indem die Siliziumoberfläche mit den Molekülen derart in Kontakt gebracht wird, dass diese nach der Methode des Abscheidens der selbstorganisierten Monolagen (SAM) an der Siliziumoberfläche über die Cyangruppe binden, und anschließend ein Topkonakt aufgebracht wird.

In einem bevorzugten Ausführungsbeispiel werden die organischen Moleküle auf eine nitridierte Siliziumoberfläche aufgebracht.

Ausführungsbeispiele der Erfindung sind in den Zeichnungen dargestellt und in der nachfolgenden Beschreibung näher erläutert.
- Figur 1: zeigt ein Reaktionsschema zur Herstellung von 2'-Amino-4-ethinylphenyl-4'-ethinylphenyl-5'-nitro-1-benzonitril.
- Figur 2: zeigt eine schematische Darstellung des Aufbaus eines nichtflüchtigen Speicherelementes mit organischen Molekülen gemäß der Erfindung.

### Beispiel

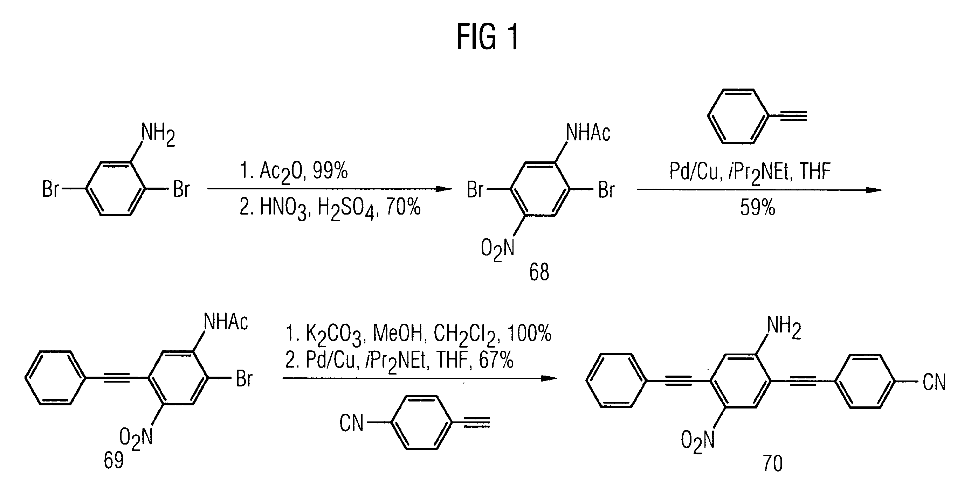

Schematisch ist der Reaktionsverlauf zur Herstellung von 2'-Amino-4-ethinylphenyl-4'-ethinylphenyl-5'-nitro-1-benzonitril in Figur 1 dargestellt. Die Synthese von 2,5-Dibrom-4-nitroacetanilid ist in Moroni et al. (Macromolecules 1997, 30, 1964-1972) ausführlich beschrieben. Das 2,5-Dibrom-4-nitroacetanilid wird mit Phenylacetylen unter Einwirkung eines Pd/Cu-Katalysators gekoppelt. Die Acetylschutzgruppe wird anschließend unter Einwirkung von Kaliumcarbonat und Methanol entfernt. Dieses Zwischenprodukt wird schlussendlich unter Einwirkung eines Pd/Cu-Katalysators mit der das Nitril enthaltenden Endgruppe zum Endprodukt gekoppelt. Weitere Grundbausteine, die resistive Speichereigenschaften zeigen, sind 4,4'-Di(ethinylphenyl)-1-benzen und 4,4'-Di(ethinyl-phenyl)-2'-nitro-1-benzen.

Die Sililzium-Elektrodenstruktur wird auf der Grundlage der SOI-Technologie hergestellt. Hierbei wird ein oxidierter Si-Wafer mit einem reinen Si-Wafer unter hohem Druck und hoher Temperatur zusammengepresst und nachfolgend die Si-Waferseite mittels CMP abgedünnt. Für die Ätzung der Si-Bahnen können derzeitige Si-Ätztechniken wie z.B. Trockenätzen mittels reaktivem Plasmaätzen auf der Basis von HBr und O₂ oder SF₆ eingesetzt werden.

Zum Auftragen des nach obiger Vorschrift hergestellten organischen Moleküls wird das Si-Substrat in die Lösung mit dem organischen Molekül eingetaucht. Nach der Abscheidung wird das Substrat gespült und im trockenen N₂-Gasstrom getrocknet.

Grundlage des Ausführungsbeispiels ist ein p-Si (100) Wafer, der mit funktionellen CMOS Technologieelementen entsprechend dem Stand der Technik versehen ist.

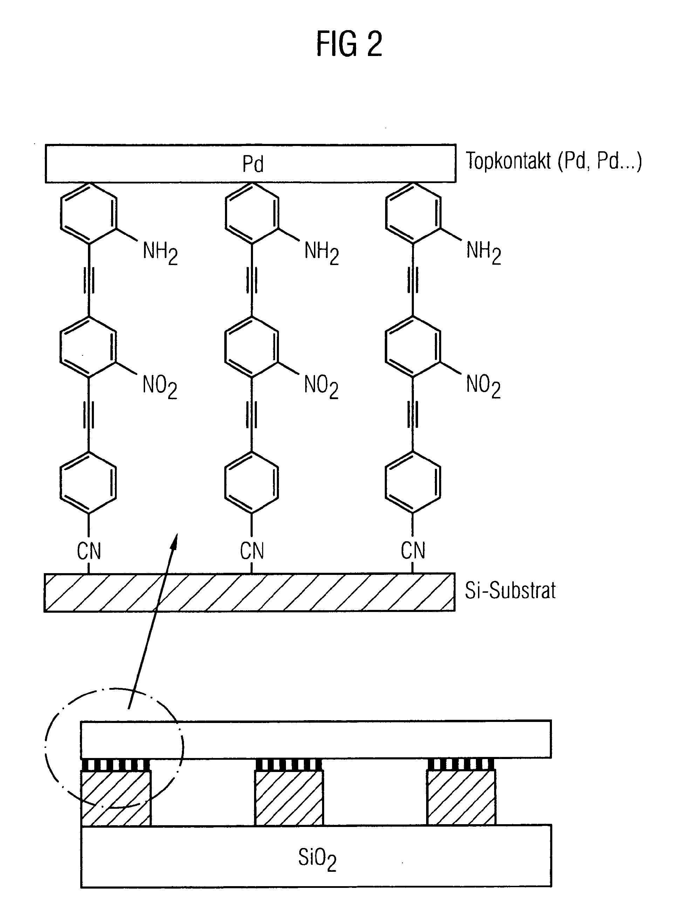

Die Auftragung eines solchen organischen Moleküls auf ein Silicium-Substrat ist in Figur 2 dargestellt. Hier kann die Oberfläche mittels klassischer Methoden strukturiert werden. Die Auftragung erfolgt mittels der Technologie der selbstorganisierten Monlagen. Als Top-Kontakt wird Palladium verwendet.

## Patentansprüche

1. Nichtflüchtiges Speicherelement in einer Halbleiterstruktur, das mindestens zwei Kontakte, von denen ein Kontakt aus Silizium besteht, und eine Monolage leitender organischer Moleküle, die eine leitende Verbindung zwischen den beiden Kontakten herstellen, umfasst, wobei das organische Molekül alternierend Ethinyl- und Arylgruppen mit mindestens einer Gruppe, ausgewählt aus Benzonitril, Phenylacetonitril, Benzoylacetonitril, Benzoylcyanid, an dem Ende des Moleküls enthält, mit dem das Molekül über die Cyangruppe an den Siliziumkontakt bindet.

2. Speicherelement nach Anspruch 1, **dadurch gekennzeichnet, dass** mindestens eine Arylgruppe mit einer elektronenziehenden Gruppe substituiert ist.

3. Speicherelement nach Anspruch 2, **dadurch gekennzeichnet, dass** die elektronenziehende Gruppe NH₂ oder NO₂ ist.

4. Speicherelement nach Anspruch 1, **dadurch gekennzeichnet, dass** mindestens eine Arylgruppe ein substituiertes oder unsubstituiertes Pyridin ist.

5. Speicherelement nach Anspruch 1, **dadurch gekennzeichnet, dass** die Gruppe, die an den Siliziumkontakt bindet, bevorzugt Benzonitril oder Phenylacetonitril ist.

6. Speicherelement nach Anspruch 1, **dadurch gekennzeichnet, dass** der Siliziumkontakt eine nitridierte Siliziumoberfläche ist.

7. Speicherelement nach Anspruch 1, **dadurch gekennzeichnet, dass** das organische Molekül folgende allgemeine Formel I besitzt: 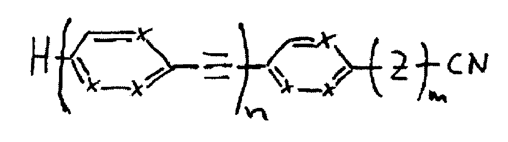 wobei
n eine ganze Zahl von 0 bis 10 ist,
m 0 oder 1 ist,
Z eine Linkergruppe ist, die CH₂, CO oder COCH₂ sein kann, und
X unabhängig voneinander in jedem Molekül C-H, N oder C-Y sein kann, wobei Y eine elektronenziehende Gruppe ist.

8. Speicherelement nach Anspruch 7, **dadurch gekennzeichnet, dass** die elektronenziehende Gruppe Y bevorzugt NH₂ oder NO₂ ist.

9. Speicherelement nach Anspruch 7, **dadurch gekennzeichnet, dass** Z bevorzugt eine CH₂-Gruppe ist oder m = 0 ist.

10. Speicherelement nach Anspruch 7, **dadurch gekennzeichnet, dass** n bevorzugt im Bereich von 1 bis 5 liegt, noch bevorzugter 2, 3 oder 4 ist.

11. Speicherelement nach Anspruch 1 oder 7, **dadurch gekennzeichnet, dass** der zweite Kontakt ein mit Palladium beschichtetes Kohlenstoffnanoröhrchen oder Gold ist.

12. Verfahren zur Herstellung eines nichtflüchtigen Speicherelements, auf dem in Teilen eine Siliziumoberfläche bereitstellt wird, auf der organische Moleküle, die alternierend Ethinyl- und Arylgruppen mit mindestens einer Gruppe, ausgewählt aus Benzonitril, Phenylacetonitril, Benzoylacetonitril und Benzoylcyanid, an dem Ende der Moleküle enthalten, mit dem die Moleküle über die Cyangruppe an die Siliziumoberfläche binden, aufgebracht werden, indem die Siliziumoberfläche mit den Molekülen derart in Kontakt gebracht wird, dass diese nach der Methode des Abscheidens der selbstorganisierten Monolagen (SAM) an der Siliziumoberfläche über die Cyangruppe binden, und anschließend ein Topkonakt aufgebracht wird.

13. Verfahren nach Anspruch 12, **dadurch gekennzeichnet, dass** die Siliziumoberfläche, auf dem die organischen Moleküle aufgebracht werden, nitridiert ist.
